# EUROPÄISCHE PATENTANMELDUNG

(11) **EP 1 382 412 A1**
(43) Veröffentlichungstag der Anmeldung: **21.01.2004**
(21) Anmeldenummer: 02078290.0
(22) Anmeldetag: 19.07.2002
(51) Int. Cl.: B23K 20/00

(54) **Vorrichtung mit einer Elektrode für die Bildung einer Kugel am Ende eines Drahtes**

(71) Anmelder: Esec Trading S.A., 6330 Cham (CH)
(72) Erfinder: Thuerlemann, Silvan, 6314 Unterägeri (CH)
(74) Vertreter: Falk, Urs, Dr.

(57) **Zusammenfassung**

Bei einer Vorrichtung für die Bildung einer Drahtkugel am Ende eines Drahtes (2) ist eine ein- und ausschwenkbare Elektrode (13) mit einer länglichen Form direkt, oder indirekt über ein Verbindungsteil (9), an der Welle eines Motors (7) befestigt, so dass die Elektrode (13) beim Ein- und Ausschwenken im wesentlichen um ihre Längsachse gedreht wird. Die Massenträgheit der Elektrode (13) bezüglich der Drehachse (8) ist gering, weshalb sie mit geringem Energieaufwand gedreht werden kann. Beim Ein- und Ausschwenken wird die Elektrode (13) zwischen einer unteren Endlage, in der sich eine für die Funkenbildung benötigte Fläche, die sogenannte Abflammfahne (17), unterhalb der Kapillare (3) des Wire Bonders befindet, und einer oberen Endlage, in der sich die Abflammfahne (17) seitlich erhöht neben der Kapillare (3) befindet, hin und her gedreht.

## Beschreibung

Die Erfindung betrifft eine Vorrichtung mit einer Elektrode für die Bildung einer Kugel am Ende eines Drahtes der im Oberbegriff des Anspruchs 1 genannten Art.

Solche Vorrichtungen werden auf sogenannten Wire Bondern verwendet. Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonden. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonden. Nach dem Befestigen des Drahtes auf dem Anschlusspunkt des Substrats wird der Draht abgerissen und der nächste Bondzyklus kann beginnen.

Um das aus der Kapillare herausragende Ende des Drahtes zu einer Kugel zu formen, wird zwischen dem Draht und der Elektrode eine DC-Hochspannung angelegt, so dass ein elektrischer Funken entsteht, der den Draht aufschmilzt. Die Spannung, bei der der elektrische Durchschlag der ionisierten Luft zwischen dem Draht und der Elektrode erfolgt und sich der Funken bildet, wird als Funkenspannung bezeichnet.

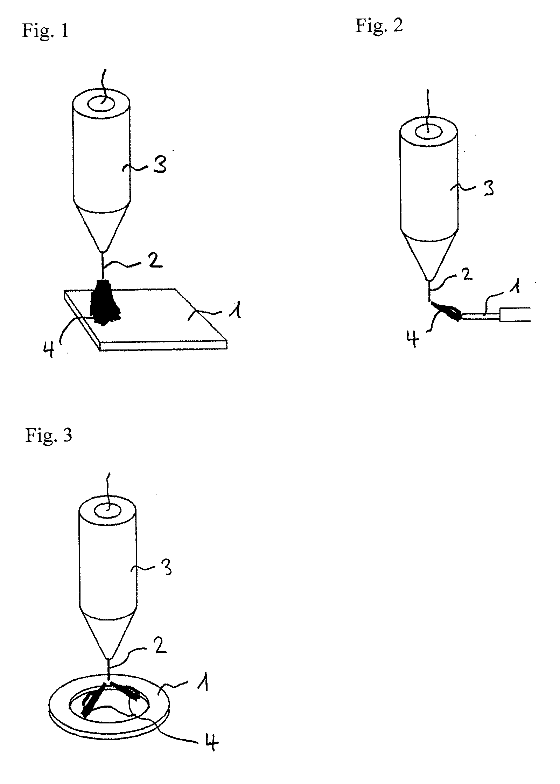

Heutzutage sind drei Typen von Vorrichtungen für die Bildung einer Drahtkugel (engl. ball) am Ende eines Drahtes bekannt, die sich im Markt durchgesetzt haben. Diese drei Typen werden anhand der Figuren 1 bis 3 erläutert. Beim ersten Typ (Fig. 1) wird eine flache Elektrode 1 von der Seite her unter die den Draht 2 führende Kapillare 3 eingeschwenkt. Bei dieser Anordnung von Elektrode und Draht bildet sich der elektrische Funken 4 in Längsrichtung des Drahtes aus. Der elektrische Funken 4 verläuft somit symmetrisch zum Draht. Der Vorteil dieses Typs ist, dass die Symmetrie der gebildeten Kugel vergleichsweise hoch ist. Nachteilig ist hingegen, dass das Ein- und Ausschwenken der Elektrode Zeit kostet. Zudem kann das Ein- und Ausschwenken der Elektrode den Bondkopf zu Schwingungen anregen.

Beim zweiten Typ (Fig. 2) ist eine Elektrode 1 mit einer Spitze seitlich versetzt unterhalb der Kapillare angeordnet. Bei dieser Anordnung verläuft der elektrische Funken 4 nicht symmetrisch zur Längsachse des Drahtes, was tendenziell zur Bildung von asymmetrischen Drahtkugeln führt. Allerdings weist die Asymmetrie dieser Drahtkugeln eine Vorzugsrichtung aus. Dies ermöglicht es, die Asymmetrie mit zusätzlichen Massnahmen zu reduzieren. Diese Anordnung erfordert zudem eine im Vergleich zum ersten Typ höhere Funkenspannung. Dies führt bei gleichem vertikalem Abstand zur Niederhalteplatte, die sich unmittelbar unterhalb der Vorrichtung befindet und die Anschlussfinger des Substrates fixiert, zu einer grösseren Häufigkeit von elektrischen Durchschlägen auf die Niederhalteplatte.

Beim dritten Typ (Fig. 3) ist die Elektrode 1 eine rotationssymmetrische Lochelektrode. Nach der Bildung der Drahtkugel wird die Kapillare 3 durch die Elektrode hindurch abgesenkt. Der Vorteil dieser Anordnung ist, dass die zur Bildung des elektrischen Funkens nötige Spannung geringer als bei den ersten beiden Typen ist. Der Nachteil ist, dass der Ort, wo der elektrische Funken 4 entsteht, ständig variiert. Auch mit dieser Vorrichtung erzeugte Drahtkugeln neigen zu Asymmetrien, allerdings weisen diese Asymmetrien keine Vorzugsrichtung auf.

Aus der europäischen Patentanmeldung EP 562 224 ist eine weitere Vorrichtung für die Bildung einer Drahtkugel bekannt. Diese Vorrichtung weist drei spitzige Elektroden auf, die elektrisch separat angesteuert werden, um die durch die einzelnen Elektroden fliessenden Ströme zu regeln.

Der Erfindung liegt die Aufgabe zugrunde, eine Vorrichtung für die Bildung einer Kugel am Ende eines Drahtes zu entwickeln, die sich durch eine tiefe Funkenspannung auszeichnet und mit der sich Drahtkugeln erzeugen lassen, die symmetrisch zur Längsachse des Drahtes sind und deren Grösse möglichst wenig streut.

Die genannte Aufgabe wird erfindungsgemäss gelöst durch die Merkmale der Ansprüche 1 und 2.

Die Erfindung besteht darin, bei einer Vorrichtung für die Bildung einer Kugel am Ende eines Drahtes eine ein- und ausschwenkbare Elektrode mit einer länglichen Form zu verwenden, die direkt, oder indirekt über ein Verbindungsteil, an der Welle eines Motors befestigt ist, so dass die Elektrode beim Ein- und Ausschwenken im wesentlichen um ihre Längsachse gedreht wird. (Die Drehachse und die Längsachse der Elektrode fallen zwar nicht unbedingt zusammen). Die Elektrode ist bevorzugt in drei zueinander abgewinkelte Abschnitte unterteilt. Die Form der Elektrode kann im weitesten Sinne als s-förmig bezeichnet werden. Die Massenträgheit der Elektrode bezüglich der Drehachse ist gering. Die Elektrode kann deshalb mit geringem Energieaufwand gedreht werden. Beim Ein- und Ausschwenken wird die Elektrode zwischen einer unteren Endlage, in der sich eine für die Funkenbildung benötigte Fläche, die sogenannte Abflammfahne, unterhalb der Kapillare des Wire Bonders befindet, und einer oberen Endlage, in der sich die Abflammfahne seitlich erhöht neben der Kapillare befindet, hin und her gedreht.

Nachfolgend werden Ausführungsbeispiele der Erfindung anhand der Zeichnung näher erläutert.

Es zeigen:
- Fig. 1-3: drei Typen von Vorrichtungen zur Bildung einer Drahtkugel am Ende eines Drahtes aus dem Stand der Technik,
- Fig. 4: in perspektivischer Ansicht ein erstes Ausführungsbeispiel einer erfindungsgemässen Vorrichtung zur Bildung einer Drahtkugel am Ende eines Drahtes,
- Fig. 5, 6: weitere schematische Ansichten der Vorrichtung, und
- Fig. 7: ein weiteres Ausführungsbeispiel einer erfindungsgemässen Vorrichtung.

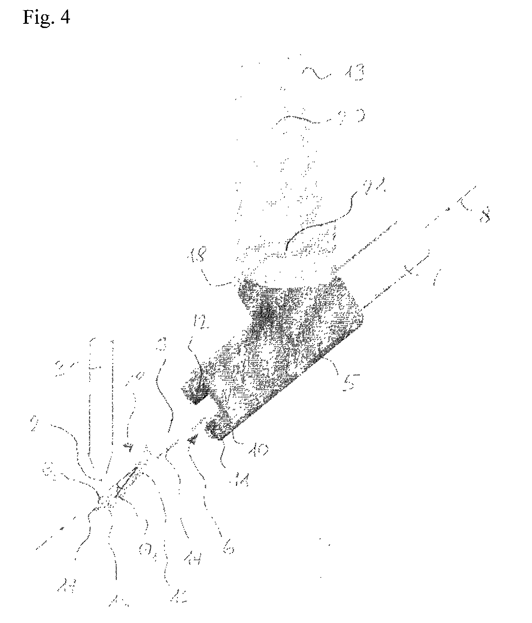

Die Fig. 4 zeigt in perspektivischer Ansicht ein Ausführungsbeispiel einer erfindungsgemässen Vorrichtung zur Bildung einer Drahtkugel am Ende eines Drahtes 2 für den Einsatz auf einem Wire Bonder. Die Vorrichtung ist seitlich neben der Kapillare 3 am nicht dargestellten Bondkopf des Wire Bonders befestigt. Die Vorrichtung umfasst einen Körper 5 mit einer Längsbohrung 6. Am hinteren Ende des Körpers 5 ist ein Motor 7 befestigt, der eine nicht sichtbare Welle aufweist. Die Welle des Motors 7 ragt in die Längsbohrung 6 hinein und definiert eine Drehachse 8,die in Richtung der Längsbohrung 6 verläuft. An der Welle ist ein Verbindungsteil 9 aus Kunststoff befestigt. Der Körper 5 weist an seinem vorderen Ende eine durch zwei Flächen 11 und 12 begrenzte Ausnehmung auf. Das Verbindungsteil 9 weist einen quer zur Längsbohrung 6 verlaufenden Nocken 10 auf, der in diese Ausnehmung hineinragt. Die Flächen 11 und 12 dienen als Anschlag für den Nocken 10. Am Verbindungsteil 9 ist eine metallische Elektrode 13 befestigt. Die Elektrode 13 weist eine längliche Form auf und ist in drei Abschnitte 14 - 16 unterteilt, die zueinander abgewinkelt sind. Der erste Abschnitt 14 der Elektrode 13 ist am Verbindungsteil 9 befestigt und verläuft entlang der Drehachse 8 oder parallel zur Drehachse 8. Der zweite, mittlere Abschnitt 15 der Elektrode 13 verläuft schräg zur Drehachse 8 und schliesst mit ihr einen vorbestimmten Winkel θ₁ ein. Der dritte Abschnitt 16 der Elektrode 13 bildet das freie Ende der Elektrode 13 und wird als Abflammfahne 17 bezeichnet, da dieser Teil der Elektrode 13 für die Funkenbildung zum Draht vorgesehen ist. Die Abflammfahne 17 ist bevorzugt als ebene Fläche ausgebildet. Die Abflammfahne 17 schliesst mit dem mittleren Abschnitt 15 der Elektrode 13 einen vorbestimmten Winkel θ₂ so ein, dass die Abflammfahne 17 zur Drehachse 8 zeigt. Der Motor 7 dreht die Elektrode 13 zwischen einer unteren und einer oberen Endlage hin und her. Die längliche Elektrode 13 rotiert dabei um die Drehachse 8. In der unteren Endlage kommt der Nocken 10 an der Fläche 11 zum Anschlag. In der oberen Endlage kommt der Nocken 10 an der Fläche 12 zum Anschlag.

Der Körper 5 weist einen Sockel 18 auf, dessen Oberfläche waagrecht verläuft. Am Sockel 18 ist ein Befestigungsteil 19 mit einer Schraube lösbar befestigt (Die Schraube ist in der Figur nicht dargestellt). Das Befestigungsteil 19 weist zwei Schlitze 20 und 21 auf, damit einerseits der Körper 5 verstellbar am Befestigungsteil 19 und andererseits das Befestigungsteil 19 am Bondkopf des Wire Bonders befestigt werden kann. Dank des Schlitzes 21 kann die Höhe der Vorrichtung genau eingestellt werden. Dank des Schlitzes 20 kann der Sockel 18 gegenüber dem Befestigungsteil 19 in beiden horizontalen Richtungen verschoben und gedreht werden. Somit kann die Lage der Drehachse 8 so justiert werden, dass sich die Abflammfahne 17 in der gewünschten Lage unterhalb der Kapillare 3 befindet.

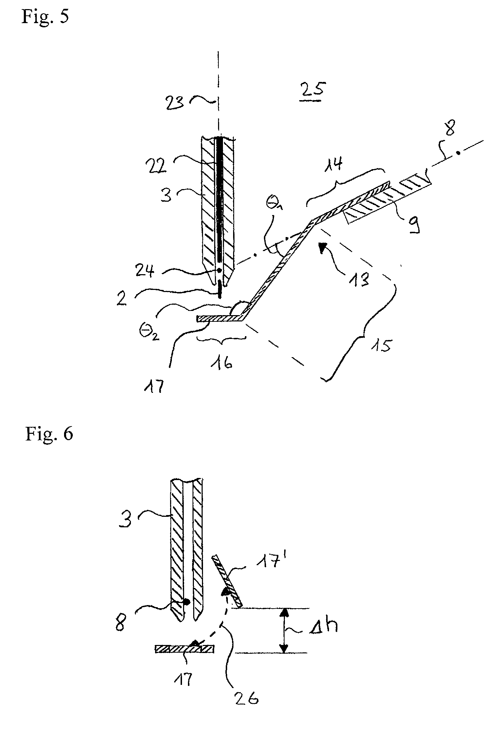

Die Fig. 5 zeigt schematisch die Kapillare 3 eines Wire Bonders und in Teilen die erfindungsgemässe Vorrichtung zur Bildung einer Drahtkugel am Ende des aus der Kapillare 3 herausragenden Drahtes 2. Der Draht 2 wird durch eine Längsbohrung 22 der Kapillare 3 geführt. Die Längsbohrung 22 der Kapillare 3 definiert eine Längsachse 23. Die Längsachse 23 der Kapillare 3 und die Drehachse 8 der Vorrichtung schneiden sich in einem Punkt 24 (aus Gründen der zeichnerischen Klarheit ist der Draht 2 hier unterbrochen dargestellt) und spannen daher eine Ebene 25 auf. Die Fig. 5 zeigt die Kapillare 3 und die Vorrichtung im Schnitt durch diese Ebene 25. Die Elektrode 13 befindet sich eingeschwenkt unterhalb der Kapillare 3 in der unteren Endlage, in der die Längsachse 23 der Kapillare 3 orthogonal zur Abflammfahne 17 verläuft.

Die Fig. 6 zeigt schematisch die Kapillare 3 und die beiden Endlagen der Abflammfahne 17 in Blickrichtung entlang der Drehachse 8, wobei die Drehachse 8 die Zeichenebene unter senkrechtem Winkel schneidet. Die Abflammfahne 17 bzw. 17' befindet sich so nahe wie möglich bei der Drehachse 8. Im Beispiel beträgt der Abstand zwischen der Drehachse 8 und dem vorderen Rand der Abflammfahne 17 etwa 3 bis 4 mm. Kein Punkt der Elektrode 13 ist mehr als 4 mm von der Drehachse 8 entfernt. Bei der Drehung von der unteren Endlage in die obere Endlage wird die Abflammfahne 17 um die Distanz Δh angehoben, die typischerweise etwa 2 - 3 mm beträgt. Die Drehbewegung der Abflammfahne 17 um die Drehachse 8 von der unteren Endlage in die obere Endlage ist als gestrichelte Linie 26 dargestellt.

Für die Bildung einer Drahtkugel am Ende des Drahtes 2 wird zwischen dem Draht 2 und der Elektrode 13 eine elektrische Spannung angelegt. Zu diesem Zweck sind der Draht 2 und die Elektrode 13 durch einen an sich aus dem Stand der Technik bekannten Funkengenerator verbunden. Der Funkengenerator besteht im wesentlichen aus einer Konstantstromquelle. Um den elektrischen Funken zwischen dem Drahtende und der Abflammfahne 17 der Elektrode 13 bilden zu können, muss die dazwischen liegende Luft ionisiert werden, bis ein elektrischer Durchschlag stattfindet und somit der Funken entsteht. Dazu wird über der Konstantstromquelle eine zunehmende Gleichspannung aufgebaut, bis der Durchschlag erfolgt. Der erste Abschnitt 14 der Elektrode 13 ist über ein nicht dargestelltes Kabel mit dem Funkengenerator verbunden.

Nachdem die Drahtkugel gebildet worden ist, wird der Motor 7 betätigt, um die Elektrode 13 in die obere Endlage zu drehen, in der sich ihre Abflammfahne 17 seitlich erhöht neben der Kapillare 3 befindet. Bei dieser Drehung gewinnt die Abflammfahne 17 an Höhe. Nun kann die Kapillare 3 abgesenkt und die Drahtkugel auf dem Halbleiterchip gebondet werden.

Die erfindungsgemässe Vorrichtung weist mehrere Vorteile auf:
- Im angehobenen Zustand, d.h. in der oberen Endlage, befindet sich die Abflammfahne 17 seitlich erhöht neben der Kapillare 3. Bei den ein- und ausschwenkbaren Elektroden gemäss dem Stand der Technik ändert sich die Höhe der Elektrode beim Ein- und Ausschwenken nicht oder nur unwesentlich. Die Höhe, auf die die Kapillare 3 und die Elektrode 13 jeweils angehoben werden müssen, damit das Substrat weitertransportiert werden kann, kann daher gegenüber dem Stand der Technik um etwa 2 mm reduziert werden, was die Dauer des Bondzyklus verkleinert.
- Die Drehachse 8, um die die Elektrode 13 zum Ein- und Ausschwenken gedreht wird, und die Hauptachse des Massenträgheitsmoments der Elektrode 13 fallen zwar nicht zusammen, liegen aber nahe beieinander. Die Elektrode 13 kann daher mit wesentlich geringerem Energieaufwand als im Stand der Technik ein- und ausgeschwenkt werden. Aus diesem Grund kann ein kleinerer und damit leichterer Motor 7 eingesetzt werden. Die Reduktion der Masse, die für die Drehung der Elektrode 13 bewegt werden muss, hat einerseits zur Folge, dass das Ein- und Ausschwenken der Elektrode 13 den Bondkopf in weit geringeren Masse zu Schwingungen anregt, und andererseits, dass das Gesamtgewicht des Bondkopfs reduziert wird.

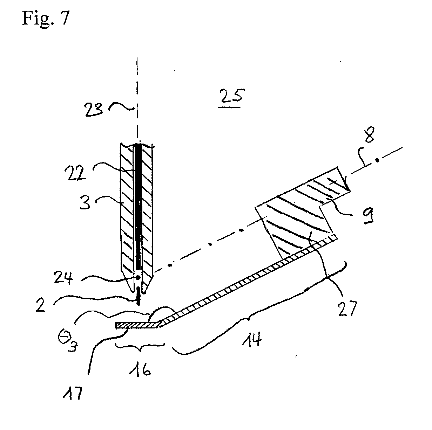

Die Fig. 7 zeigt in der gleichen Darstellungsart wie die Fig. 5 ein weiteres Ausführungsbeispiel einer erfindungsgemässen Vorrichtung zur Bildung einer Drahtkugel am Ende des aus der Kapillare 3 herausragenden Drahtes 2. Die Längsachse 29 der Kapillare 3 und die zur Waagrechten und zur Senkrechten schräg verlaufende Drehachse 8 der Vorrichtung schneiden sich wiederum in einem Punkt 30 und spannen die Ebene 31 auf. Die Elektrode 13 befindet sich eingeschwenkt unterhalb der Kapillare 3 in der unteren Endlage, in der die Längsachse 29 der Kapillare 3 orthogonal zur Abflammfahne 17 verläuft. Bei diesem Ausführungsbeispiel ist die längliche Elektrode 13 nur in zwei zueinander abgewinkelte Abschnitte 14 und 16 unterteilt. Die beiden Abschnitte 14 und 16 schliessen einen vorbestimmten Winkel θ₃ ein. Das Verbindungsteil 9 ist verbreitert und weist beispielsweise einen Fortsatz 27 auf, an dem der Abschnitt 14 der Elektrode 13 befestigt ist. Der Abschnitt 14 der Elektrode 13 verläuft parallel zur Drehachse 8. Bei diesem Ausführungsbeispiel ist das Massenträgheitsmoment bezüglich der Drehachse 8 etwas grösser als beim ersten Ausführungsbeispiel. Da auch bei diesem Ausführungsbeispiel kein Punkt der Elektrode 13 mehr als 4 mm von der Drehachse 8 entfernt ist, kann die Elektrode 13 noch immer mit geringem Energieaufwand um die Drehachse 8 gedreht werden.

Aus Herstellungsgründen ist es vorteilhaft, wenn der erste Abschnitt 14 der Elektrode 13 sowohl beim ersten wie beim zweiten Ausführungsbeispiel parallel zur Drehachse 8 verläuft. Allerdings sind auch andere Konstruktionen möglich, wo dies nicht der Fall ist und wo die Vorteile der Erfindung dennoch gegeben sind. Unter Umständen ist es auch möglich, die Elektrode 13 direkt an der Welle des Motors 7 zu befestigen und das Verbindungsteil 9 wegzulassen.

## Patentansprüche

1. Vorrichtung mit einer ein- und ausschwenkbaren Elektrode (13) für die Bildung einer Kugel am Ende eines Drahts (2), wobei der Draht (2) durch eine Längsbohrung (28) einer Kapillare (3) verläuft und aus der Kapillare (3) herausragt, wobei die Elektrode (13) zum Ein- und Ausschwenken um eine Drehachse (8) zwischen einer ersten Endlage und einer zweiten Endlage hin und her gedreht wird und wobei die Elektrode (13) eine Abflammfahne (17) aufweist, **dadurch gekennzeichnet, dass** die Drehachse (8) schräg zu einer durch die Längsbohrung (28) der Kapillare (3) definierten Längsachse (29) verläuft und mit der Längsachse (29) einen vorbestimmten Winkel einschliesst, dass die Elektrode (13) eine längliche Form aufweist, die in mindestens zwei Abschnitte (14, 16; 14-16) unterteilt ist, dass ein erster Abschnitt (14) der Elektrode (13) an einer Welle eines Motors (7) oder an einem an einer Welle eines Motors (7) befestigten Verbindungsteil (9) befestigt ist und dass ein zweiter Abschnitt (16) der Elektrode (13), der die Abflammfahne (17) bildet, mit dem ersten Abschnitt (14) einen vorbestimmten Winkel (θ₃) einschliesst, so dass sich die Abflammfahne (17) der Elektrode (13) in der ersten Endlage unterhalb der Kapillare (3) und in der zweiten Endlage seitlich erhöht neben der Kapillare (3) befindet.

2. Vorrichtung mit einer ein- und ausschwenkbaren Elektrode (13) für die Bildung einer Kugel am Ende eines Drahts (2), wobei der Draht (2) durch eine Längsbohrung (28) einer Kapillare (3) verläuft und aus der Kapillare (3) herausragt, wobei die Elektrode (13) zum Ein- und Ausschwenken um eine Drehachse (8) zwischen einer ersten Endlage und einer zweiten Endlage hin und her gedreht wird und wobei die Elektrode (13) eine Abflammfahne (17) aufweist, **dadurch gekennzeichnet, dass** die Drehachse (8) schräg zu einer durch die Längsbohrung (28) der Kapillare (3) definierten Längsachse (29) verläuft und mit der Längsachse (29) einen vorbestimmten Winkel einschliesst, dass die Elektrode (13) eine längliche Form aufweist, die in drei Abschnitte (14-16) unterteilt ist, dass der erste Abschnitt (14) der Elektrode (13) an einer Welle eines Motors (7) oder an einem an einer Welle eines Motors (7) befestigten Verbindungsteil (9) befestigt ist, dass der zweite, mittlere Abschnitt (15) der Elektrode (13) mit der Drehachse (8) einen ersten vorbestimmten Winkel (θ₁) einschliesst und dass der dritte Abschnitt (16) der Elektrode (13), der die Abflammfahne (17) bildet, mit dem mittleren Abschnitt (15) einen zweiten vorbestimmten Winkel (θ₂) einschliesst, so dass sich die Abflammfahne (17) der Elektrode (13) in der ersten Endlage unterhalb der Kapillare (3) und in der zweiten Endlage seitlich erhöht neben der Kapillare (3) befindet.

3. Vorrichtung nach Anspruch 1 oder 2, **dadurch gekennzeichnet, dass** kein Punkt der Elektrode (13) mehr als 4 mm von der Drehachse (8) entfernt ist.
